# EUROPÄISCHE PATENTSCHRIFT

(11) **EP 0 557 850 B1**
(45) Veröffentlichungstag und Bekanntmachung des Hinweises auf die Patenterteilung: **11.12.1996**
(21) Anmeldenummer: 93102352.7
(22) Anmeldetag: 15.02.1993
(51) Int. Cl.: H03K 17/08

(54) **Schaltungsanordnung zur Laststrombegrenzung eines Leistungs-MOSFET**
Circuit arrangement for limiting the load current of a power MOSFET
Montage servant à limiter le courant de charge d'un MOSFET de puissance

(30) Priorität: 25.02.1992 DE 4205753
(43) Veröffentlichungstag der Anmeldung: 01.09.1993
(73) Patentinhaber: SIEMENS AKTIENGESELLSCHAFT, 80333 München (DE)
(72) Erfinder: Leipold, Ludwig, Dipl.-Ing., W-8000 München 40 (DE); Sander, Rainald, Dipl.-Ing., W-8000 München 40 (DE); Tihanyi, Jenö, Dr. Dipl.-Ing., W-8000 München 21 (DE)

(56) Entgegenhaltungen:
- EP-A- 0 369 048
- EP-A- 0 384 937
- DE-A- 3 445 340
- FR-A- 2 564 261
- PROCEEDINGS OF THE 3RD INTERNATIONAL SYMPOSIUM ON POWER SEMICONDUCTOR DEVICES
- AND IC'S 22. April 1991, Baltimore,Seiten 242 - 247 FUJIHIRA et al.:'Self- isolation NMOS-DMOS technology for automotive low-side switches'
- PATENT ABSTRACTS OF JAPAN, Bd. 15, Nr. 444 (E-1132)12. November 1991;& JP-A-3187516

## Beschreibung

Die Erfindung bezieht sich auf eine Schaltungsanordnung zur Begrenzung des durch einen Leistungs-MOSFET fließenden Stroms, mit einem Spannungsteiler, an dessen Knoten eine der Drain-Sourcespannung des Leistungs-MOSFET folgende Spannung abfällt und mit einem Steuertransistor, dessen Laststrecke zwischen Gateanschluß und Sourceanschluß des Leistungs-MOSFET angeschlossen ist und der abhängig von der Spannung am Knoten des Spannungsteilers leitend gesteuert wird, wenn die Drain-Sourcespannung des Leistungs-MOSFET einen vorgegebenen Wert übersteigt.

Eine solche Schaltunganordnung ist beipielsweise in der EP-0 369 048 Al beschrieben worden. Bei dieser Schaltungsanordnung liegt der Spannungsteiler parallel zur Reihenschaltung aus dem Leistungs-MOSFET und der Last. Der Knoten des Spannungsteilers ist mit dem Steueranschluß des Steuertransistors verbunden. Steigt die Drain-Sourcespannung des Leistungs-MOSFET z. B. durch einen Kurzschluß der Last an, so erhöht sich die Gate-Sourcespannung des zwischen dem Gateanschluß und dem Sourceanschluß des Leistungs-MOSFET liegenden Steuertransistors. Wird dessen Einsatzspannung überschritten, so beginnt er zu leiten und die Gate-Sourcespannung des Leistungs-MOSFET wird herabgesetzt. Damit wird der den Leistungs-MOSFET durchfließende Strom geringer und eine Überlastung kann vermieden werden. Da der Sourceanschluß des Leistungs-MOSFET und der Fußpunkt des Spannungsteilers auf/verschiedenen Potentialen liegen, ist diese Schaltungsanordnung für eine Integration schlecht geeignet.

Eine Schaltungsanordnung der oben genannten Art, in der der Sourceanschluß des Leistungs-MOSFET direkt mit dem Fußpunkt/des Spannungsteilers verbunden ist, ist beispielsweise in der DE 34 45 340 beschrieben worden.

Ziel der Erfindung ist es, eine Schaltungsanordnung der angegebenen Art so weiterzubilden, daß sie gut integrierbar ist.

Diese Ziel wird erreicht durch die Merkmale:
a) Mit dem Steueranschluß des Steuertransistors ist der Drainanschluß eines Depletion-FET verbunden,
b) der Sourceanschluß des Depletion-FET ist mit dem Knoten des Spannungsteilers verbunden,
c) der Steueranschluß des Steuertransistors ist über einen Widerstand mit dem Gateanschluß des Leistungs-MOSFET verbunden,
d) der Gateanschluß des Depletion-FET ist mit dem Sourceanschluß des Leistungs-MOSFET verbunden.

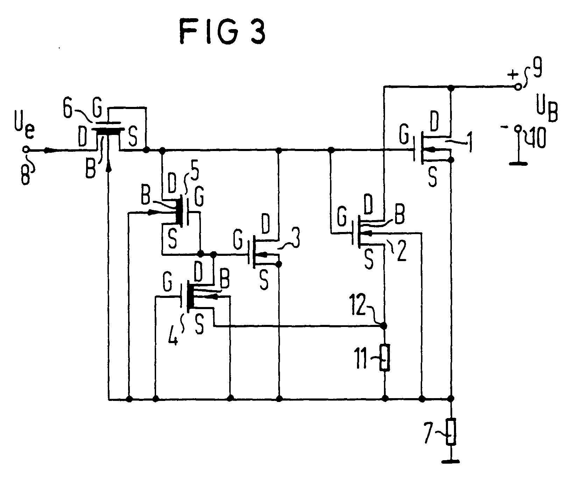

Weiterbildungen der Erfindung sind Gegenstand der abhängigen Ansprüche. Die Erfindung wird anhand dreier Ausführungsbeispiele in Verbindung mit den Figuren 1 bis 3 näher erläutert. Es zeigen:
- Figur 1: eine Schaltungsanordnung zur Regelung des Laststroms durch einen Leistungs-MOSFET mit sourceseitiger Last,
- Figur 2: eine entsprechende Schaltungsanordnung mit drainseitiger Last,
- Figur 3: eine einfach integrierbare Version der Schaltungsanordnung nach Figur 1.

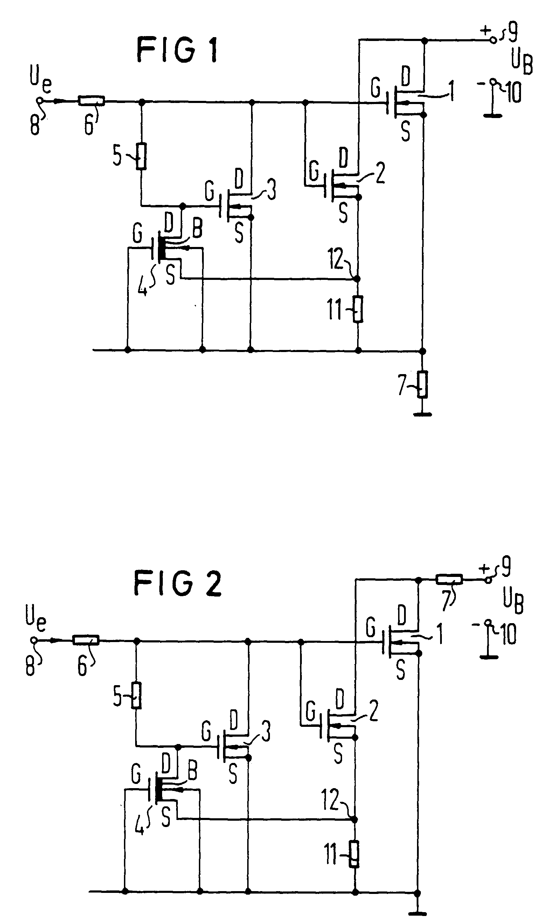

Die Schaltungsanordnung nach Figur 1 enthält einen Leistungs-MOSFET 1 mit einem Gateanschluß G, einem Sourceanschluß S und einem Drainanschluß D. Dem Leistungs-MOSFET 1 ist sourceseitig eine Last 7 in Reihe geschaltet. Diese Reihenschaltung liegt über zwei Anschlüsse 9, 10 an einer Betriebsspannung U_{B}. Zwischen dem Drainanschluß D und dem Sourceanschluß S ist ein Spannungsteiler angeschlossen, der aus einem Enhancement-FET 2 und einem Widerstand 11 besteht. Dabei ist der Widerstand 11 mit dem Sourceanschluß S und der Drainanschluß D des FET 2 mit dem Drainanschluß D des Leistungs-MOSFET 1 verbunden. Der Gateanschluß G des FET 2 ist mit dem Gateanschluß G des Leistungs-MOSFET 1 verbunden. Zwischen den Gateanschluß des Leistungs-MOSFET und seinen Sourceanschluß ist die Drain-Sourcestrecke eines Steuertransistors 3 geschaltet. Zwischen den Gateanschluß G des Steuertransistors 3 und den Knoten 12 des Spannungsteilers 2, 11 ist die Drain-Sourcestrecke eines Depletion-FET 4 geschaltet, wobei sein Sourceanschluß mit dem Knoten 12 verbunden ist. Der Gateanschluß G und der Substratanschluß B des Depletion-FET 4 ist mit dem Sourceanschluß des Leistungs-MOSFET 1 verbunden. Der Gateanschluß G des Steuertransistors 3 ist außerdem über einen hochohmigen Widerstand 5 mit dem Gateanschluß des Leistungs-MOSFET 1 verbunden. Beide Gateanschlüsse liegen über einen Widerstand 6 an einem Eingangsanschluß 8.

Wird an den Eingangsanschluß 8 eine Steuerspannung Uₑ angelegt, so wird der Leistungs-MOSFET 1 leitend gesteuert und ein Laststrom fließt. Das aus dem Widerstand 5, dem Depletion FET 4 und dem Spannungsteiler 2, 11 bestehenden Netzwerk ist so ausgelegt, daß der Steuertransistor 3 gesperrt bleibt, solange die Drain-Sourcespannung des Leistungs-MOSFET unter einem vorgegebenen Wert liegt. Steigt der Laststrom z. B. durch einen Kurzschluß in der Last 7 an, so erhöht sich die Drain-Sourcespannung am Leistungs-MOSFET 1. Damit erhöht sich auch die Spannung am Spannungsteiler 2, 11 und der Depletion-FET 4 wird weniger leitend. Damit kann die Gate-Sourcekapazität des Steuertransistors 3 über die Widerstände 6 und 5 aufgeladen werden und dieser wird leitend. Damit wird die Steuerspannung des Leistungs-MOS-FET 1 herabgesetzt und der Laststrom wird reduziert.

Zur klaren Definition der Schwelle, bei der der Steuertransistor 3 leitend gesteuert werden soll, empfiehlt es sich, den Spannungsteiler 2, 11 derart zu bemessen, daß der FET 2 bereits bei Nennstrom des Leistungs-MOSFET 1 in Sättigung arbeitet. Dann bildet sich die Erhöhung der Drain-Sourcespannung des Leistungs-MOSFET nahezu ausschließlich am Knoten 12 und damit am Sourceanschluß des Depletion-FET 4 ab. Damit läßt sich eine Sperrung des Depletion-FET schon bei kleinem Spannungshub erzielen.

Eine noch steilere Abschaltkennlinie des Depletion-FET 4 wird dadurch erzielt, daß, wie erwähnt, der Substratanschluß auf dem gleichen Potential mit dem Gateanschluß des Depletion FET 4 und auf dem gleichen Potential wie der Sourceanschluß des Leistungs-MOSFET 1 liegt. Damit wird der normalerweise leitende Kanal des Depletion-FET 4 sowohl von der Oberfläche als auch von der Substratseite her in seiner Leitfähigkeit moduliert und eine sehr steile I/U-Kennlinie des Depletion-FET 4 wird erreicht. Der Depletion-FET funktioniert aber auch, wenn sein Substratanschluß B mit seinem Sourceanschluß verbunden wird. Die I/U-Kennlinie ist dann aber weniger steil.

Die Schaltungsanordnung nach Figur 2 unterscheidet sich von der nach Figur 1 lediglich dadurch, daß hier die Last 7 zwischen Drainanschluß D des Leistungs-MOSFET 1 und dem Versorgungsspannungsanschluß 9 liegt. Die Funktionsweise ist die gleiche.

Eine noch einfacher integrierbare Anordnung läßt sich dadurch schaffen, daß neben den Feldeffekttransistoren 1, 2, 3, 4 auch die Widerstände 5 und 6 als Feldeffekttransistoren ausgebildet sind. Ihre Gateanschlüsse sind jeweils mit ihren Sourceanschlüssen verbunden. Somit arbeiten sie als Stromquellen. Ihre Substratanschlüsse B sind mit den Substratanschlüssen der Feldeffekttransistoren 1, 2, 3 und 4 verbunden.

Als allgemeine Regel für die Bemessung der Widerstände 6, 5 und 11 gilt, daß der Widerstand 5 etwa 2 bis 3 Größenordnungen hochohmiger sein muß als die Widerstände 6 und 11. Der Widerstand 6 kann z.B. zwischen 1 und 10 KOhm betragen, der Widerstand 5 1 M Ohm und der Widerstand 11 l KOhm.

## Patentansprüche

1. Schaltungsanordnung zur Begrenzung des durch einen Leistungs-MOSFET (1) fließenden Stroms, mit einem Spannungsteiler (2, 11), an dessen Knoten (12) eine der Drain-Sourcespannung des Leistungs-MOSFET folgende Spannung abfällt und mit einem Steuertransistor (3), dessen Laststrecke zwischen Gateanschluß und Sourceanschluß des Leistungs-MOSFET angeschlossen ist und der abhängig von der Spannung am Knoten des Spannungsteilers leitend gesteuert wird, wenn die Drain-Sourcespannung des Leistungs-MOSFET einen vorgegebenen Wert übersteigt,
**gekennzeichnet durch** die Merkmale:
a) Mit dem Steueranschluß des Steuertransistors (3) ist der Drainanschluß eines Depletion-FET (4) verbunden,
b) der Sourceanschluß des Depletion-FET (4) ist mit dem Knoten (12) des Spannungsteilers (2, 11) verbunden,
c) der Steueranschluß des Steuertransistors ist über einen Widerstand (5) mit dem Gateanschluß des Leistungstransistors (1) verbunden,
d) der Gateanschluß des Depletion-FET ist mit dem Sourceanschluß des Leistungs-FET verbunden.

2. Schaltungsanordnung nach Anspruch 1,
**dadurch gekennzeichnet**, daß der Spannungsteiler einen MOSFET (2) und einen Widerstand (11) enthält, daß ein Anschluß des Widerstandes mit dem Sourceanschluß (S) des Leistungs-MOSFET (1) verbunden ist, und daß der MOSFET (2) und der Widerstand (11) derart bemessen sind, daß der MOSFET bei der bei Nennstrom am Leistungs-MOSFET (1) abfallenden Drain-Sourcespannung im Sättigungsbereich arbeitet.

3. Schaltungsanordnung nach Anspruch 1 oder 2,
**dadurch gekennzeichnet**, daß das Substrat des Depletion-FET (4) mit dem Sourceanschluß (S) des Leistungs-MOSFET (1) verbunden ist.

4. Schaltungsanordnung nach Anspruch 1,
**dadurch gekennzeichnet**, daß der zwischen dem Gateanschluß des Leistungs-MOSFET (1) und dem Steueranschluß des Steuertransistors (3) liegende Widerstand (5) als Stromquelle ausgebildet ist.

5. Schaltungsanordnung nach einem der Ansprüche 1 bis 4,
**dadurch gekennzeichnet**, daß der Steuertransistor (3) ein Enhancement-MOSFET ist.

## Claims

1. Circuit arrangement for limiting the current flowing through a power MOSFET (1), having a voltage divider (2, 11), at the node (12) of which a voltage following the drain-source voltage of the power MOSFET is present, and having a control transistor (3), the load path of which is connected between the gate terminal and source terminal of the power MOSFET and which is switched on, as a function of the voltage at the node of the voltage divider, when the drain-source voltage of the power MOSFET exceeds a predetermined value,
characterized by the features:
a) the drain terminal of a depletion-mode FET (4) is connected to the control terminal of the control transistor (3),
b) the source terminal of the depletion-mode FET (4) is connected to the node (12) of the voltage divider (2, 11),
c) the control terminal of the control transistor is connected to the gate terminal of the power transistor (1) via a resistor (5),
d) the gate terminal of the depletion-mode FET is connected to the source terminal of the power FET.

2. Circuit arrangement according to Claim 1, characterized in that the voltage divider contains a MOSFET (2) and a resistor (11), in that one terminal of the resistor is connected to the source terminal (S) of the power MOSFET (1) and in that the MOSFET (2) and the resistor (11) are dimensioned in such a way that the MOSFET operates in the saturation region in the event of the drain-source voltage drop across the power MOSFET (1) at rated current.

3. Circuit arrangement according to Claim 1 or 2, characterized in that the substrate of the depletion-mode FET (4) is connected to the source terminal (S) of the power MOSFET (1).

4. Circuit arrangement according to Claim 1, characterized in that the resistor (5) connected between the gate terminal of the power MOSFET (1) and the control terminal of the control transistor (3) is designed as a current source.

5. Circuit arrangement according to one of Claims 1 to 4, characterized in that the control transistor (3) is an enhancement-mode MOSFET.

## Revendications

1. Montage destiné à limiter le courant passant dans un MOSFET de puissance (1), comportant un diviseur de tension (2, 11), au noeud (12) duquel une tension suivant la tension drain-source du MOSFET de puissance chute, et un transistor de commande (3), dont la voie de charge est branchée entre la borne de grille et la borne de source du MOSFET de puissance et qui est commandé à l'état conducteur en fonction de la tension au noeud du diviseur de tension lorsque la tension drain-source du MOSFET de puissance devient supérieure à une valeur prédéterminée,
caractérisé par les caractéristiques suivantes :
a) la borne de drain d'un FET à déplétion (4) est reliée à la borne de commande du transistor de commande (3),
b) la borne de source du FET à déplétion (4) est reliée au noeud (12) du diviseur de tension (2, 11),
c) la borne de commande du transistor de commande est reliée par l'intermédiaire d'une résistance (5) à la borne de grille du transistor de puissance (1),
d) la borne de grille du FET à déplétion est reliée à la borne de source du MOSFET de puissance.

2. Montage selon la revendication 1,
caractérisé par le fait que le diviseur de tension contient un MOSFET (2) et une résistance (11), qu'une borne de la résistance est reliée à la borne de source (S) du MOSFET de puissance (1), et que le MOSFET (2) et la résistance (11) ont des dimensions telles que le MOSFET fonctionne en saturation dans le cas où la tension drain-source chute pour un courant nominal au MOSFET de puissance (1).

3. Montage selon la revendication 1 ou 2,
caractérisé par le fait que le substrat du FET à déplétion (4) est relié à la borne de source (S) du MOSFET de puissance (1).

4. Montage selon la revendication 1,
caractérisé par le fait que la résistance (5) qui se trouve entre la borne de grille du MOSFET de puissance (1) et la borne de commande du transistor de commande (3) est conçue comme une source de courant.

5. Montage selon l'une des revendications 1 à 4,
caractérisé par le fait que le transistor de commande (3) est un MOSFET à enrichissement.
